# EUROPEAN PATENT APPLICATION

(11) **EP 4 033 547 A1**
(43) Date of publication of application: **27.07.2022**
(21) Application number: 20866760.0
(22) Date of filing: 28.06.2020
(51) Int. Cl.: H01L 33/54, H01L 25/075, H01L 33/62, H01L 33/48, H01L 33/52

(54) **LIGHT-EMITTING DIODE PACKAGE ASSEMBLY**

(30) Priority: 18.09.2019 CN 201921554474 U; 18.09.2019 CN 201921554475 U; 09.03.2020 CN 202020278177 U
(71) Applicant: Quanzhou Sanan Semiconductor Technology Co., Ltd., Quanzhou, Fujian 362343 (CN)
(72) Inventor: XIN, Shuning, Xiamen, Fujian 361009 (CN); LIN, Zhen-duan, Xiamen, Fujian 361009 (CN); LIAO, Yanqiu, Xiamen, Fujian 361009 (CN); SHI, Junpeng, Xiamen, Fujian 361009 (CN); CAO, Aihua, Xiamen, Fujian 361009 (CN); YU, Changchin, Xiamen, Fujian 361009 (CN); HSU, Chen-ke, Xiamen, Fujian 361009 (CN); LIAO, Chi-wei, Xiamen, Fujian 361009 (CN); LEE, Chia-en, Xiamen, Fujian 361009 (CN); WU, Zheng, Xiamen, Fujian 361009 (CN)
(74) Representative: Petraz, Gilberto Luigi
(86) International application number: PCT/CN2020/098502
(87) International publication number: WO 2021/051924

(57) **Abstract**

A light-emitting diode (LED) package assembly, comprising a plurality of light-emitting units arranged in a matrix of m×n, wherein m and n are integers, and m×n≥4; each light-emitting unit comprises a first LED chip, a second LED chip, and a third LED chip; each LED chip (100) comprises a first surface and a second surface opposite to each other, and a side surface connected between the first surface and the second surface, and an electrode group (110) formed on the second surface; the electrode group (110) comprises a first electrode (111) and a second electrode (112); and the first surface is a light-exiting surface; a package layer (200) filling a gap between the LED chips (100) and covering side walls of the LED chips (100); and a wiring layer formed above second surfaces of the plurality of LED chips (100).

## Description

### RELATED APPLICATIONS

Priority: China Utility Model Patent Application No. 201921554474.5, entitled "Light-emitting Diode Package Assembly", filed on Sep. 18, 2019, China Utility Model Patent Application No. 201921554475.X, entitled "Light-emitting Diode Package Assembly", filed on Sep. 18, 2019, and China Utility Model Patent Application No. 202020278177.9, entitled "Light-emitting Diode Package Assembly", filed on Mar. 9, 2020. The entire contents of the above applications are incorporated by reference in this application.

### TECHNICAL FIELD

The present invention relates to a package assembly, in particular a light-emitting diode package assembly, and a light-emitting device having the light-emitting diode package assembly.

### BACKGROUND

Nowadays, light-emitting diode (LED) is one of the most popular light source technologies and can be used as light sources for lighting devices as well as various electronic products, for example, various display devices such as TVs, cellular phones, PCs , notebook PCs, personal digital assistants (PDAs), etc. Reducing the size of LED devices can improve the resolution of the display, thus expanding the application fields of LED displays, such as cell phones, car panels, TVs, computers, video conferencing, etc. Currently, the mainstream displays use a package size of 2121 and 1010. With the development of technology, a package size of 0808 or even smaller has emerged.

### SUMMARY

### TECHNICAL PROBLEM

### SOLUTION TO THE PROBLEM

### TECHNICAL SOLUTION

The object of the present invention is to provide an ultra-small pitch light-emitting diode package assembly that includes a plurality of pixel regions arranged in an m×n array, where m and n are integers greater than one. Each pixel region PX can be called as a pixel.

In some embodiments, a light-emitting diode package assembly includes a plurality of light-emitting units arranged in an m×n array, where m and n are integers and m×n ≥ 4, each light-emitting unit including a first LED chip, a second LED chip and a third LED chip, each LED chip including a first surface, a second surface opposite to the first surface, a side surface interconnecting the first surface and the second surface, and an electrode set formed on the second surface, the electrode set including a first electrode and a second electrode, the first surface being a light-exiting surface; an encapsulation layer filling gaps between the LED chips and covering sidewalls of the LED chips; and a wiring layer formed on the second surface of the plurality of LED chips.

In some embodiments, the LED chips of each light-emitting unit are arranged in a column in a first direction, and the first electrode and the second electrode of each LED chip are arranged side by side in a second direction.

In some embodiments, the wiring layer connects in parallel the first electrodes of the first LED chip, second LED chip and third LED chip of two or more adjacent light-emitting units in a third direction, and connects in parallel the second electrodes of the first LED chip, second LED chip and third LED chip of two or more adjacent light-emitting units in a fourth direction, thereby electrically connecting the plurality of light-emitting units to form an all-in-one light-emitting module. The third direction is the same as the first direction and the fourth direction is the same as the second direction, or the third direction is the same as the second direction and the fourth direction is the same as the first direction.

In some embodiments, the LED package assembly does not have a package substrate for carrying the LED chips, and the LED chips are held in position by the encapsulation layer.

Further, in the package assembly having an N-in-one light-emitting module, where N=m×n, a distance D1 between adjacent light-emitting units is 0.8 mm or less. N may be an integer greater than or equal to 4, such as 4, 6, 8, 9, 16, 32 or 64, etc. The larger the value of N, the smaller the value of D1 is. For example, when N is 4-9, D1 can be 0.4-0.8, and when N is 8 or more, then D can be 0.1-0.4.

In some embodiments, the package assembly also includes pads for external connections. The number of the pads P is n + m × a, where a is the number of LED chips for each light-emitting unit, and n ≥ m. By such a configuration, the number of pads of the package assembly can be reduced as much as possible, on the one hand, to facilitate the wiring, on the other hand, to facilitate placement of chip at the application end, reducing the risk of short circuit.

In some embodiments, the LED package assembly includes a plurality of light-emitting units arranged in an m×n array, where m and n are integers and m×n ≥ 2, each light-emitting unit including a first LED chip, a second LED chip and a third LED chip, each LED chip including a first surface, a second surface opposite to the first surface, a side surface interconnecting the first surface and the second surface, and an electrode set formed on the second surface, the electrode set including a first electrode and a second electrode, the first surface being a light-exiting surface, the LED chips of each light-emitting unit being arranged in a column in a first direction, the first electrode and the second electrode of each LED chip being arranged side by side in a second direction, the first electrodes and the second electrodes of two adjacent columns of the LED chips are in opposite positions; an encapsulation layer filling gaps between the LED chips and covering sidewalls of the LED chips; and a wiring layer formed on the second surface of the plurality of LED chips, the wiring layer electrically connecting the plurality of light-emitting units to form an all-in-one light-emitting module.

In some embodiments, the wiring layer connects in parallel the first electrodes of the first, second and third LED chips of two or more adjacent light emitting units in the first direction, and connects in parallel the second electrodes of the first, second and third LED chips of two or more adjacent light emitting units in the second direction, thereby electrically connecting the plurality of light emitting units to form an all-in-one light emitting module.

The function and effect of the invention include that it adopts the form of packaging without substrate, in which the LED chips of multiple light-emitting units are held by an encapsulation layer, and the LED chips of the multiple light-emitting units are connected in series or in parallel by forming a multi-layer wiring layer on the back of the multi-layer light-emitting units. The first wiring layer connects the LED chips of multiple pixel regions in series and parallel, and through the via layer and the second wiring layer, rewiring is carried out to form an integrated thin and small-pitch light-emitting diode package assembly. In addition, by a reasonable wiring layer, on the one hand, it can reduce the number of pads of the package assembly for external connection, reducing the difficulty of placement of chips at the application end, while improving the reliability of the product. Further, the number of layers of the wiring layer is no more than four, which ensures that the product is thin and light, facilitating thin and light design of the end products.

Another object of the present invention is to provide a small-pitch and high-reliability light-emitting diode package assembly.

The light emitting diode package assembly comprises a plurality of LED chips spaced apart from each other, each LED chip comprising a first surface, a second surface opposite to the first surface, a side surface interconnecting the first surface and the second surface, and an electrode set formed on the second surface, the electrode set comprising a first electrode and a second electrode, the first surface being a light emitting surface; an encapsulation layer filling the gaps between the LED chips and covering sidewalls of the LED chips, exposing the first and second electrodes of the LED chips; and a wiring layer formed on the second surface of the LED chips.

The wiring layer includes multiple layers of conductive wires. A first layer of conductive wires is connected to the electrode set of the LED chip, and the relationship between a minimum wire width W of each layer of wires and a thickness T of the layer is as follows: W ≤ T ≤ 2W.

In the above light emitting diode package assembly, the package assembly does not have a package substrate for carrying the LED chips, and the LED chips are held in position by the package layer and is physically supported by the wiring layer and the encapsulation layer with sufficient strength, so the thickness T and minimum wire width W of the conductive wires of each layer of the wiring layer directly determines the reliability of the package assembly. The size of the package assembly and the distance between the chips determine the minimum wire width W of the conductive wires. The minimum wire widths W for individual layers of conductive wires are usually not exactly the same. Therefore, by configuring the relationship between the minimum wire width W of each layer of wires and the thickness T of the layer as W ≤ T ≤ 2W, on the one hand, it achieves the wire thickness required by overall packaging, providing sufficient mechanical strength for the device, on the other hand, it takes into account the exposure of conductive wires and yield of thick electrode coating.

Preferably, the thicknesses of layers of the multilayer conductive wires are not the same. In some embodiments, at least one layer of the multilayer conductive wires has a thickness of 50 µm or less and at least one layer has a thickness of 60 µm or more.

Preferably, the melting point of the multilayer conductive wires is 400°C or more. Preferably, the multilayer conductive wires can be made of a single metal of fine conductivity, such as Ag, Cu, Ni, Al and other materials. In some implementations, the above metal materials can form metal bonds with the electrodes of the LED chip through processes such as electroplating, chemistry plating, printing, etc.

In some embodiments, a protective layer is provided on a surface of at least one layer of the multilayer conductive wires. The protective layer includes a material that is very thin and stable at high temperatures, preferably a material with resistance to electromigration, corrosion and oxidation. The protective layer has a thickness of 50~200 nm.

Preferably, the minimum wire width W of each layer of the multilayer conductive wires is 10 µm or more, for example, it may be 10~60 µm.

In some embodiments, the encapsulation layer is made of a colored material layer with a light transmittance preferably not higher than 30%, and fills the gaps between the multiple LED chips and covers the sidewalls of the LED chips, which can prevent the optical crosstalk between the LED chips. Further, a transparent or translucent light-transmissive layer can be formed on the light-exiting surfaces of the multiple LED chips, which on the one hand can protect the light-exiting surfaces of the LED chips, and on the other hand can be used as a light scattering layer to produce a light scattering effect. It reduces dizziness when the LED package assembly is finally used in display panels. Further, the light-transmitting layer may include a light-scattering material, such as scattering particles. The transmittance of the light-transmissive layer can be adjusted according to different needs so as to achieve the best display effect. For example, when applied to indoor display, a translucent material can be selected as the light-transmissive layer with a transmittance of preferably 40%~80%, which further reduces dizziness. When applied to outdoor display, a transparent layer with a transmittance preferably above 70% can be selected. The thickness of the light-transmissive layer is preferably 20 µm or less, preferably 10 µm or less, such as 10 µm or less, and the light-exiting surfaces of LED chips are located at substantially the same height (the height difference is 10 µm or less), which is conducive to unifying the light-exiting surfaces and reducing light crosstalk between sidewalls when the pixel regions of the package assembly are significantly increased.

Further, the package assembly also comprises an insulating layer formed on the encapsulation layer and covering one or more layers of conductive wires of the wiring layer. Preferably, the insulating layer comprises one or more layers, at least one layer of which has a hardness greater than that of the conductive wires.

In some embodiments, the plurality of LED chips form multiple light-emitting units arranged in a m×n array, which constitutes an N-in-one light-emitting module, where n and m are integers greater than 1. Each of the light-emitting units include a first LED chip, a second LED chip and a third LED chip. The distance between the light-emitting units is 1mm or less. A distance D1 between adjacent light-emitting units is preferably 0.8 mm or less. N may be an integer greater than or equal to 4, such as 4, 6, 8, 9, 16, 32 or 64, etc. The larger the value of N, the smaller the value of D1 is. For example, when N is 4-9, D1 can be 0.4-0.8, and when N is 8 or more, then D can be 0.1-0.4.

Further, the package assembly also includes pads for external connection. The number of the pads P is n + m × a, where a is the number of LED chips of each the light-emitting unit, and n ≥ m. By such configuration, the number of pads of the package assembly can be reduced as much as possible, on the one hand, to facilitate the wiring, making the package assembly thin and light, on the other hand, to facilitate placement of chips at the application end, while improving the reliability of products.

### BENEFICIAL EFFECTS OF THE INVENTION

### BENEFICIAL EFFECTS

Other features and advantages of the present invention will be set forth in the subsequent specification and, in part, become apparent from the specification or are understood by carrying out the present invention. The objects and other advantages of the present invention may be achieved and obtained by means of the structures specifically indicated in the specification, the claims, and the accompanying drawings.

### BRIEF DESCRIPTION OF THE DRAWINGS

### DESCRIPTION OF THE DRAWINGS

Other features, functions and effects of the present invention will be clearly presented in embodiments with reference to the drawings.
FIG. 1 is a perspective view illustrating a structure of a light-emitting diode (LED) package assembly of the present invention.
FIG. 2 is a side sectional schematic view illustrating a structure of an LED package assembly according to an embodiment of the present invention.
FIG. 3 is a top-view schematic diagram illustrating an arrangement of LED chips of an LED package assembly according to an embodiment of the present invention.
FIG. 4 is a side sectional schematic view showing the LED chip of the LED package assembly of the embodiment is a conventional LED chip.
FIG. 5 is a side sectional schematic view illustrating a way of die bonding of the LED chips of the LED package assembly of the embodiment.
FIG. 6 is a side sectional schematic view showing a first wiring layer of the LED package assembly of the embodiment.
FIG. 7 is a top-view schematic diagram showing the first wiring layer of the LED package assembly of the embodiment.
FIG. 8 is a side sectional schematic view showing a via layer of the LED package assembly of the embodiment.
FIG. 9 is a top-view schematic diagram showing a via layer of the light-emitting diode package assembly of the present invention.
FIG. 10 is a side sectional schematic diagram showing a second wiring layer of the LED package assembly of the embodiment.
FIG. 11 is a top-view schematic diagram showing the second wiring layer of the LED package assembly of the embodiment.
FIG. 12 is a top-view schematic diagram showing the first wiring layer, the via layer, and the second wiring layer of the LED package assembly of the embodiment.
FIG. 13 is a circuit diagram illustrating circuit connections of the LED package assembly of the embodiment.
FIG. 14 is a top-view schematic diagram illustrating an arrangement of LED chips and a first wiring layer of an LED package assembly of an embodiment of the present invention.
FIG. 15 is a top-view schematic diagram showing a second wiring layer of the LED package assembly of the embodiment of the present invention.
FIG. 16 is a top-view schematic diagram showing the first wiring layer, a via layer, and a second wiring layer of the LED package assembly of the embodiment of the present invention.
FIG. 17 is a circuit diagram illustrating circuit connections of the LED package assembly of the embodiment.
FIG. 18 is a schematic diagram of circuit connection illustrating wiring connections of an LED package assembly of a further embodiment of the present invention.
FIG. 19 is a schematic diagram of circuit connection illustrating wiring connections of an LED package assembly of a further embodiment of the present invention.
FIG. 20 is a top-view schematic diagram illustrating a first wiring layer of an LED package assembly of a further embodiment of the present invention.
FIG. 21 is a top-view schematic diagram illustrating a second wiring layer of the LED package assembly of the embodiment of the present invention.
FIG. 22 is a top-view schematic diagram illustrating a third wiring layer of the LED package assembly of the embodiment of the present invention.
FIG. 23 is a side sectional schematic diagram illustrating a structure of an LED package assembly of an embodiment of the present invention.
FIG. 24 is a side sectional schematic diagram illustrating a structure of an LED package assembly of an embodiment of the present invention.
FIG. 25 is a side sectional schematic diagram illustrating a structure of an LED package assembly of an embodiment of the present invention.

### EMBODIMENTS

### EMBODIMENTS OF THE INVENTION

Before the present invention is described in detail, it should be noted that in the following description, similar components are denoted by the same number.

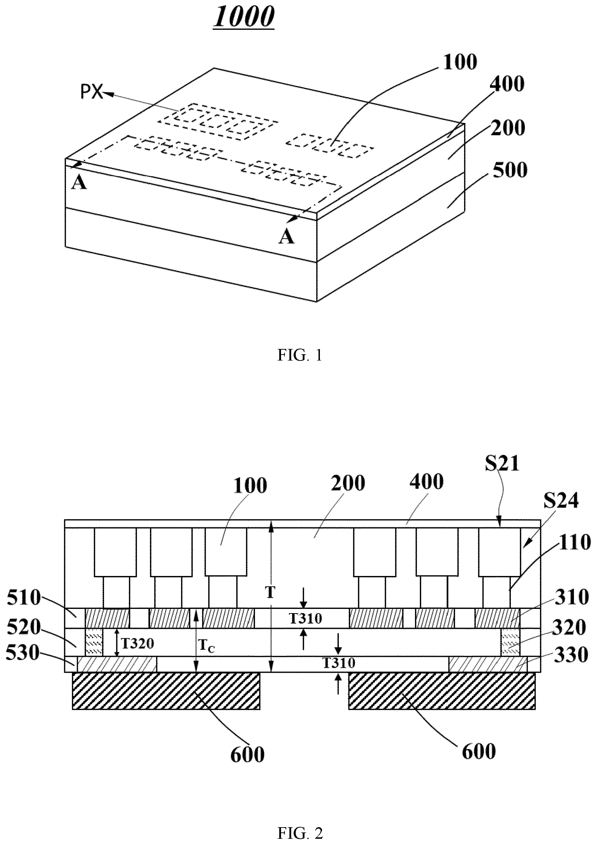

Referring to FIGS. 1-2, a light-emitting diode (LED) package assembly according to an embodiment of the present invention is provided, which is an LED package assembly without a substrate. The LED package assembly may comprise a plurality of light-emitting units arranged in an m×n array, where m and n are integers greater than 1. Each light-emitting unit includes a plurality of LED chips 100 of different wavelengths, preferably, for example, at least three LED chips emitting red light (R), green light (G), and blue light (B), respectively. It may also include an LED chip emitting white light (including a wavelength conversion layer), that is, a combination of RGBW is formed so that the brightness of a display can be enhanced, which is very beneficial for outdoor display. Each light-emitting unit is equivalent to a pixel region PX, which can also be referred to as a pixel. In a specific embodiment, the LED package assembly includes 2×2 pixel regions. Each pixel region PX includes a plurality of LED chips 100 spaced apart from one another and having an emitting surface S21. The package assembly also includes an encapsulation layer 200 that holds the plurality of LED chips 100 and fills gaps between the plurality of LED chips 100, and a multi-layer wiring layer located on the encapsulation layer. The multi-layer wiring layer includes a first wiring layer 310, a via layer 320 and a second wiring layer 330. Electrical isolation is provided between these layers by an insulating layer 500. The first wiring layer 310 is formed on the lower surfaces of the plurality of LED chips, connecting the plurality of LED chips in parallel and/or in series. The via layer 320 is formed on and electrically connected to the first wiring layer 310. The second wiring layer 330 is formed on and electrically connected to the via layer 320.

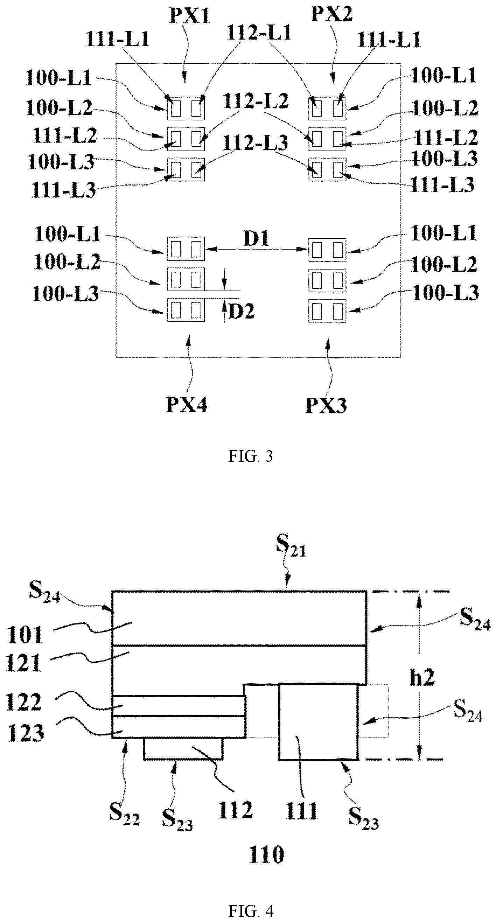

FIG. 3 briefly illustrates the arrangement of the LED chips of the package assembly. Referring to FIG. 3, the package assembly includes four pixel regions PX1~PX4, each pixel region PX including a plurality of LED chips 100, such as a first LED chip 100L1, a second LED chip 100L2, and a third LED chip 100L3. In other embodiments, each pixel region may also include only two LED chips or more than three LED chips, such as four LED chips. The three LED chips 100L1, 100L2, and 100L3 may emit light of different wavelengths, for example, they may emit red light, green light, and blue light, respectively.

Referring to FIG. 4 which shows one of the above LED chips 100L1~100L3, each of the above LED chips 100L1~100L3 has a pair of electrodes 110 on the same side, a first surface S21, a second surface S22 opposite to the first surface, a side surface S24 interconnecting the first surface S21 and the second surface S22, and an electrode surface S23. The first surface S21 is a light-exiting surface S21, and the second surface S22 is provided with the pair of electrodes 110. Further, the LED chip includes a substrate 101, a first type semiconductor layer 121, a light-emitting layer 122 and a second type semiconductor layer 123. The first type semiconductor layer 121 and the second type semiconductor layer 123 may be p-type and n-type semiconductor layers, respectively. The LED chip also includes a transparent substrate 101 located on the first type semiconductor layer 121. The LED chip electrode set 110 includes a first electrode 111 electrically connected to the first type semiconductor layer 121, and a second electrode 112 electrically connected to the second type semiconductor layer 123. In some other embodiments, each LED chip electrode set 110 also includes a thickened layer of conductive material. The thickened layer is provided between the first electrode 111 and the first wiring layer, and between the second electrode 112 and the first wiring layer 310, respectively, and can be formed by electroplating, chemical plating or printing, etc. The material may be Cu, CuₓW or other conductive metal materials. By increasing the thickness of the electrodes, the contact area between the side surface S24 of the LED chip and the encapsulation layer 200 can be increased, and thus the adhesion between the LED chip and the encapsulation layer 200 can be improved. Preferably, the thickness of the electrode set of each LED chip is 5~200 µm, for example, it may be 5~30 µm, 30~50 µm, or 80~120 µm, depending on specific needs. The LED chip 100 may be an LED chip with a conventional size (a side of the chip is generally more than 200 µm), or Mini LED chip (the chip size is generally between 100~200 µm), or Micro LED chip (the chip size is generally no more than 100 µm). Mini LED chip or micro LED chip are preferable in the embodiment.

Referring to FIG. 3, the first, second and third chips LED-100L1 ~100-L3 in each pixel region PX of the package assembly are arranged in a straight line, and specifically, individual LED chips of each light-emitting unit are arranged in a column in a first direction, and the first and second electrodes of each LED chip are arranged side by side in a second direction, where the first direction and the second directions are substantially perpendicular to each other. In this embodiment, the first electrode 111 and the second electrode 112 are in a left-right arrangement, the polarities of the electrodes of two adjacent columns of LED chips are opposite. In other words, the electrodes of the adjacent columns of chips are symmetrical, which can facilitate wiring and thereby reducing the distance between the chips. Taking the package assembly shown in FIG. 3 as an example, the polarities of the electrodes of the three LED chips 100L1~100L3 in the first pixel region PX1 are opposite to the polarities of the electrodes of the three LED chips 100L1~L3 in the second pixel region PX2. If considering each pixel region as a pixel, the distance D1 for each pixel is preferably 1 mm, more preferably, 0.8 mm or less, for example, 0.1~0.3 mm, 0.3~0.5 mm, or 0.5~0.8 mm. The distance D2 between the chips in the same pixel region PX is preferably 100 µm or less, for example, 50~100 µm, or 50 µm or less. In some display applications, the distance between LED chips in the same pixel region is preferably 50 µm or less, for example, 40~50 µm, 30~40 µm, 20~30 µm, or 10~20 µm. The smaller the distance, the better it is to reduce the size of this LED package assembly and thus improve the resolution of the display.

Referring again to FIG. 2, a first encapsulation layer 200 is filled around the plurality of first, second, and third LED chips 100L1-100L3. Preferably, the encapsulation layer 200 has a light transmittance of less than 30%. More preferably, the encapsulation layer 200 has a light transmittance of 5%-20%. Optionally, the encapsulation layer 200 is opaque and nontransparent. Specifically, it includes light-absorbing component (not shown in the figures) provided at least around the sidewalls of the LED chips or between adjacent LED chips, or further at least around the LED semiconductor light-emitting stacked layers or between adjacent semiconductor light-emitting stacked layers. The light-absorbing component may specifically be light-absorbing particles dispersed within the epoxy resin or silicone of the encapsulation layer, such as black particles, or toner. Alternatively, the light-absorbing component may be a black resin. The light-absorbing component of the encapsulation layer 200 is provided at least around the sidewalls of the LED to prevent light-emitting form the side of the LED chips, thereby the emitted light of the LED chip is mainly from or all from the light-exiting surfaces of the LED chips, reducing crosstalk or mixing of light from different LED chips in the side direction. In a specific embodiment, the encapsulation layer 200 may be epoxy resin or silicone with black colorant, so that all areas of the entire LED packaging assembly are black, except the light-exiting surface S21 of the LED chips 100, which helps to improve the contrast of display panel. In addition, each LED chip 100 is isolated through the black encapsulation material to reduce the light interference between individual LED chips. In some embodiments, the hardness of the encapsulation layer 200 is preferably D60 or above, more preferably, D85 or more.

Further, a transparent or translucent material layer may be formed on the encapsulation layer 200 as another encapsulation layer 400, which covers the first surface S21 of the plurality of first, second, and third LED chips, preventing the LED chips from being exposed. The encapsulation layer 400 can be used as a light scattering lens to produce a light scattering effect. When the final LED packaging assembly is used in a display panel, it can effectively reduce the dizziness. Further, the illustrated encapsulation layer 400 may include a light scattering material, such as scattering particles. The thickness of the encapsulation layer 400 is preferably between 5 - 20 µm, such as 10 µm, which, on the one hand, can protect the light-exiting surface of the LED chips, and on the other hand, with the encapsulation layer 200 using a light-absorbing material, can reduce the light interference between individual LED chips. The light transmittance is preferably 40% or more. In some embodiments, the LED package assembly is used for indoor display, in which, the encapsulation layer 400 is preferably a translucent layer with a light transmittance of preferably 40%~80%, more preferably 70~80%, which can reduce the brightness of the LED chip and thereby reduce light dizziness. In some embodiments, the package assembly is used in the outdoor display, in which case the encapsulation layer 400 is preferably a transparent layer with a light transmittance of preferably 80% or more.

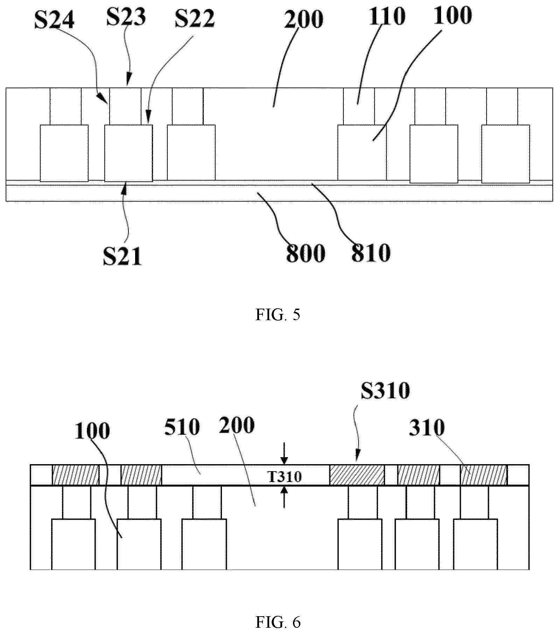

In this embodiment, the plurality of first, second, and third LED chips 100L1~L3 may first be temporarily adhered to a support 800 such as a tape by taking the light-exiting surface S21 of the LED chips 100 as a die-bonding surface, and at this time, the electrode surface S23 is facing upward. A fluid insulating material is then filled between the chips and solidified as the encapsulation layer 200, exposing the electrode surface S23 of the LED chips. As shown in FIG. 5, in this embodiment, the thickness of the adhesive material 810 of the tape 800 is preferably controlled to be 5~20 µm, which on the one hand ensures that the LED chips will not be displaced when filling the encapsulation layer, and on the other hand ensures that the first surfaces S21 of the first, second and third LED chips 100L1~L3 are substantially located at the same level with a height difference substantially below 10 µm, which unifies the light-exiting surfaces and reduces light crosstalk between sidewalls, while significantly increasing the pixel regions of the package assembly.

The multi-layer wiring layer is formed on the second surfaces of the plurality of LED chips and includes multiple layers of conductive wires in this embodiment, the multiple layers of conductive wires specifically include a first wiring layer 310, a via layer 320, and a second wiring layer 330. The first wiring layer 310 is connected to the electrodes 110 of the LED chips, the via layer 320 is formed on the first wiring layer 310, and the second wiring layer 330 is formed on the via layer 320 and is electrically connected to the first wiring layer 310 through the via layer 320. The multiple layers of conductive wires are preferably made of a metal material with a melting point higher than 400°C, such as Ag, Cu, Ni, Al, etc. The material of these layers may be the same or different, and may be formed by electroplating, chemical plating or printing, etc. The thickness of each layer is preferably 100 µm or less, such as 20~80 µm. In this embodiment, the LED package assembly does not have a package substrate for carrying the LED chips, and the LED chips 100 are held in position by the encapsulation layer 200 and physically supported by the wiring layer 300 and the encapsulation layer with sufficient strength, so the wiring layer 300 needs to have a sufficient thickness for providing mechanical strength. The mechanical strength of the wiring layer can be increased by increasing the thickness of any layer of conductive wires, but the thickness of each layer of conductive wires should not be too large considering the need for exposure of the wires and the yield of thick electrode coating. In this embodiment, the reliability of the wiring layer can be ensured by setting the relationship between the thickness T of each conductive wire of the wiring layer and the minimum wire width W of the conductive wire of the layer. The minimum wire width W depends on the size of the package assembly and the distance between the chips, which is preferably not less than 30 µm. The relationship between the minimum wire width W for each layer of wire and the thickness T of the layer is configured to be W ≤ T ≤ 2W. The thickness of each conductive wire is not less than the minimum wire width of the layer, which can ensure that the wiring layer 300 has sufficient thickness to provide mechanical strength for the device. Meanwhile, it is required that the thickness of any layer of the conductive wire T ≤ 2W, so as to avoid a decrease in yield of any layer of the conductive wires duo to a large thickness thereof.

Referring to FIG. 6, the first wiring layer 310 is formed on the surface of the encapsulation layer 200 and are electrically connected to the electrodes 110 of the plurality of LED chips. An insulating layer 510 is filled in the gaps between the wires of the first wiring layer 310, exposing a surface S310 of the first wiring layer 310 away from the LED chips. The material of the insulating layer 510 may be the same as the material of the encapsulation layer 200, or different. When the same material is used, the insulating layer 510 and the encapsulation layer 200 form a single layer, and it is difficult to distinguish the two. In an embodiment, for example, the LED package assembly is used in a display device, and the insulating layer 510 and the encapsulation layer 200 are both epoxy resin or silicone with colorant. Preferably, the hardness of the insulating layer 510 is not less than the hardness of the first wiring layer 310, for example, D60 or above, more preferably, D85 or above, which helps to expose the surface S310 of the first wiring layer 310 by grinding.

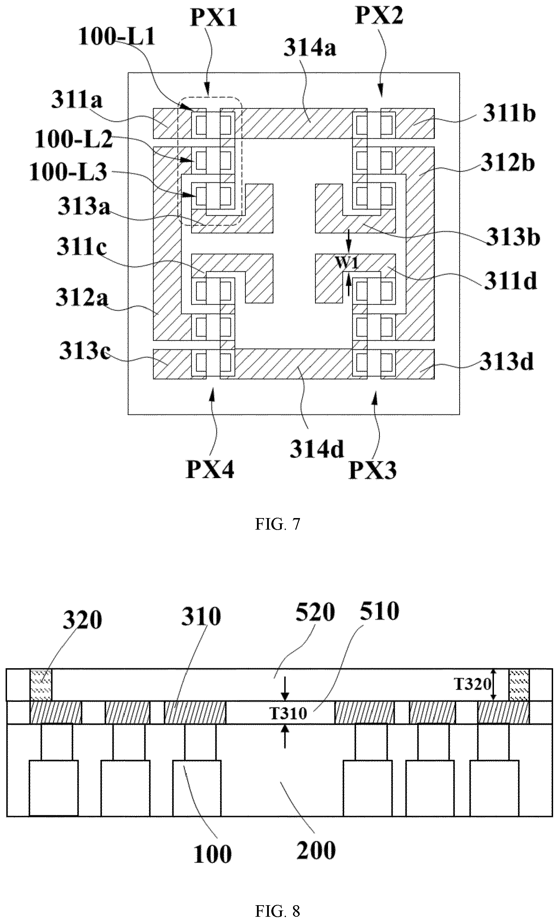

The first wiring layer 310 includes a plurality of first wires and at least two common wires, thereby electrically connecting the LED chips of the multiple pixel regions PX to form an n-in-one pixel region. FIG. 7 illustrates an example of a four-in-one package assembly, in which the LED chips of four pixel regions are connected in series and/or parallel. In other embodiments, it is not limited to a four-in-one structure, but may also be a nine-in-one or sixteen-in-one, etc. In the package assembly shown in FIG. 7, this first wiring layer 310 includes two common wires 314a, 314d and ten first wires. The first wires 311a~311d are connected to the first electrodes 111 of the first chips 100-L1 of the pixel regions PX, respectively. The wires 313a~313d are connected to the first electrodes 111 of the third chips 100-L3 of the PX. The wire 312a is connected to the first electrodes of the second LED chips 100-L2 ofPX1 and PX4. The wire 312b is connected to the first electrodes of the second LED chips 100-L2 of PX2 and PX3. The common wire 314a is connected to the second electrodes 112 of the first, second, and third LED chips of PX1 and PX2, and the common wire 314d is connected to the second electrodes 112 of the first, second, and third LED chips of PX3 and PX4. The thickness T310 of the first wiring layer 310 is preferably 1~2 times, preferably 1.2~1.8 times, the minimum wire width W1 of the first wiring layer.

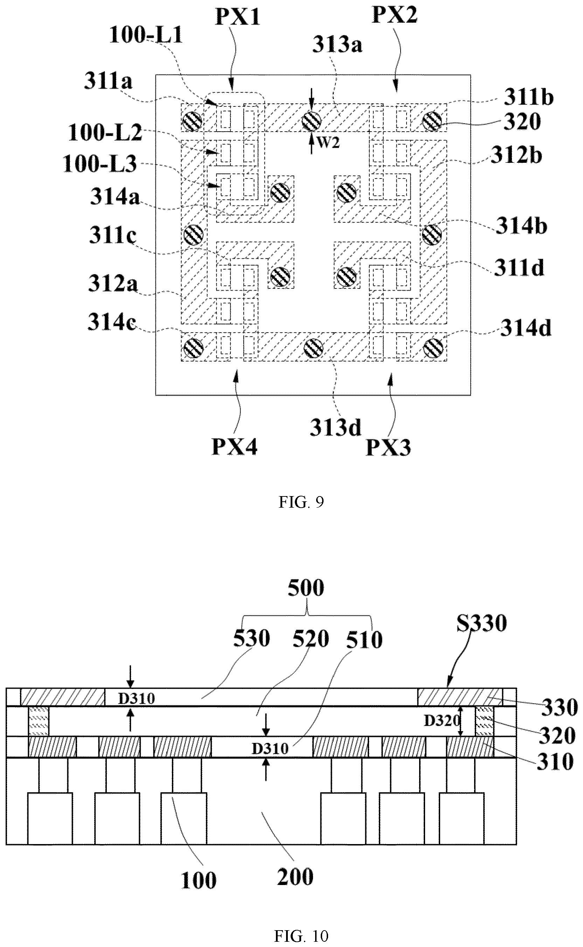

Referring to FIGS. 8 and 9, the via layer 320 is located on the surface S310 of the first wiring layer 310, including a plurality of vias 320 formed in an insulating layer 520. The number and location of the vias correspond to the individual wires of the first wiring layer. The pattern filled with solid diagonal lines in FIG. 9 represents the vias, which are as far away from each LED chip as possible. The material of the insulating layer 520 may be referred to the insulating layer 510. The thickness T320 of the via layer 320 is preferably less than 100 µm, and preferably 1~2 times the minimum wire width W2 of the via layer, for example, 1~1.2 times, 1.2~1.5 times, or 1.5~2 times, depending on different needs. In this embodiment, the diameter of the via of the layer is equal to the minimum wire width W2 of the layer, and the diameter of the via is preferably 20~60 µm. In some embodiments where the package assembly has a thinner structure, the via layer is preferably 20~50 µm, for example, 25~30 µm, so as to avoid excessive stress and thermal resistance due to the large thickness of the via layer, and reduce the total thickness of the package structure, while ensuring the strength of the package structure, making the end products thinner and lighter. In other embodiments, the via layer has a thickness of 50~80 µm, for example 60 µm, thus appropriately increasing the thickness of the package assembly and thus facilitating pickup of a device from a sidewall thereof.

Referring to FIG. 10, the second wiring layer 330 is located on the via layer 320 and forms an electrical connection with the first wiring layer 310 through the respective vias of the via layer 320. An insulating layer 530 is filled in the gaps between the wires of the third wiring layer 330, exposing a surface s330 of the second wiring layer 330 away from the LED chips. The material of the insulating layer 530 may be referred to the insulating layer 510.

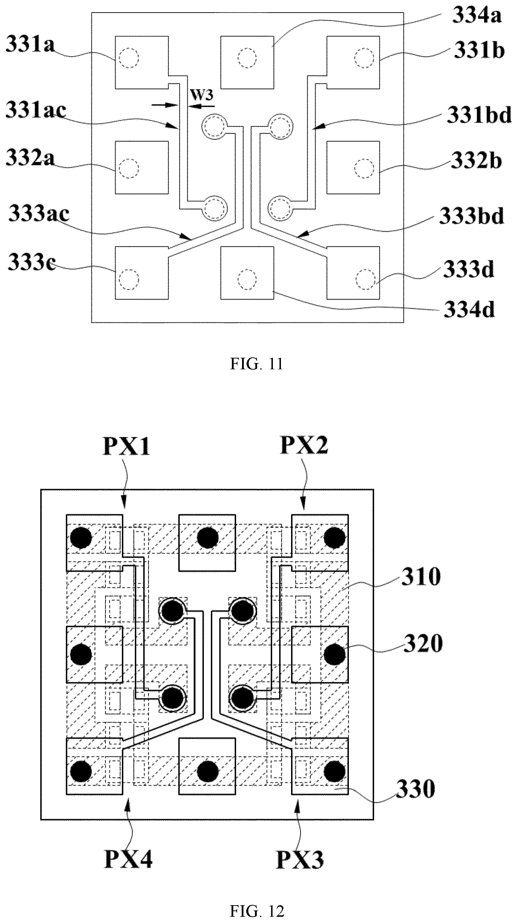

Referring to FIG. 11, the wires of the third wiring layer 330 includes a plurality of connecting wires 331ac, 331bd, 333ac, 333bd and a plurality of connecting portions 331a, 331b, 332a, 332b, 333c, 333d, 334a and 334d. The connecting wires are used to connect the electrodes of the same type of LED chips and which have the same polarity. For example, the connection 331ac connects the first electrodes 111 of the first LED chips 100-L1 of PX1 and PX3, and the connection 333ac connects the first electrodes 111 of the third LED chips 100-L3 of PX1 and PX3. The connecting portions can be used as electrode pads for external connection, for being connected to a power supply. In a preferred embodiment, a pad 600 can be made in the corresponding area of the connecting portion and the area outside the pad can be covered with ink, epoxy resin or other insulating material to protect the wires of the second wiring layer 330. In a preferable embodiment, the connecting portions of the second wiring layer 330 completely covers each via of the via layer 320, increasing the contact area between the second wiring layer and the vias. In addition, in terms of process, conductive material of the via layer and the second wiring layer can be formed in the same process, saving a process of forming conductive material and grinding, which can effectively save costs and improve product stability. The thickness T330 of the third wiring layer 330 is preferably 1~2 times, preferably 1.2~1.8 times, of the minimum wire width W3 of the third wiring layer.

The insulating layers 510~530 may be of the same material or of different materials, specifically selected from epoxy resin, silicone, polyimide, benzocyclobutene, or PBO. When composed of the same material, the insulating layers 510~530 are combined into a single layer 500, which is difficult to distinguish them. In some specific embodiments, the insulating layers 510~530 are made of opaque or low-transmittance materials, such as epoxy resin or silicone doped with a black colorant, preventing or reducing the light emitted from the LED chips from a rewiring layer which may otherwise cause crosstalk. When an opaque or low-transmittance material is used as the insulating layer, a metal wire pattern of the wiring layer can be formed first, then the insulating layer can be formed by filling, and finally the surface of the metal wires in the wiring layer can be exposed by grinding. In other embodiments, when the encapsulation layer 200 is made of a low-transmittance material or an opaque material, the insulating layers 510~530 may be partially or fully light transmissive, and the transmittance is thus higher than the that of the encapsulation layer 200. The light-transmissive layer can be made without adding colorants or light-absorbing materials, such as toner or dyes, and is preferably a silicone or epoxy resin material layer that does not contain micron-sized particles (usually particles with a diameter of 1 micron or more, such as C-powder particles), so as to avoid a decrease in reliability (e.g., a decrease in insulation performance) otherwise caused by possible defects such as unevenness and interface defects due to the addition of colorants, which can ensure the reliability of the encapsulation of the insulating layer to the wiring layer. In other embodiments, a photosensitive material is solidified to form the insulating layer, which simplifies the process. Meanwhile, the area around the chip and the non-metallic part of the electrode surface are covered with light-absorbing material as the encapsulation layer 200 to prevent crosstalk of light from the sides of the chips.

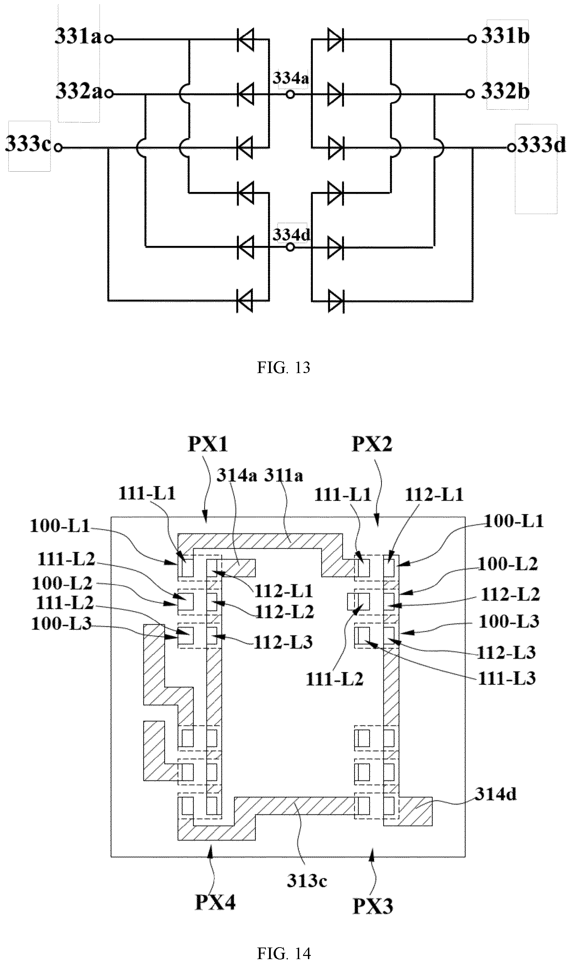

Referring to FIGS. 12 and 13, FIG. 12 shows the connection relationship of the three wiring layers, and FIG. 13 shows the equivalent circuit diagram of the four-in-one light-emitting unit. The four-in-one light-emitting unit is lead out by eight connecting portions 331a, 331b, 332a, 332b, 333c, 333d, 334a and 334d. The first electrodes of the first LED chip 100-L1 are led out by the connecting portions 331a and 331b, the first electrodes of the second LED chips 100-L2 are led out by the connecting portions 332a and 332b, and the first electrodes of the third LED chips 100-L3 are led out by the connecting portions 333c and 333d. As common electrodes, the connecting portions 334a and 334d connect the second electrodes 112 of all LED chips of PX1 to PX4, respectively.

In this embodiment, first, in the arrangement of the LED chips, the LED chips in each PX are arranged in a straight line. Specifically, respective LED chips of each light-emitting unit are arranged in a column in a first direction. The first and second electrodes of each LED chip are arranged side by side in a second direction. The first and second directions are substantially perpendicular to each other. The polarities of the electrodes of two adjacent columns of LED chips are opposite. In the first wiring layer 310, the common electrodes of the LED chips of two adjacent PX in left-right arrangement are connected into a common electrode, and the second LED chips 100-L2 (located in the middle of the three chips) of the two adjacent PX in the up-to-down direction are connected in parallel (i.e., the first electrodes of the second LED chips of PX1 and PX3 are connected in parallel and the first electrodes of the second LED chips of PX1 and PX4 are connected in parallel). The first LED chips 100-L1 and the third LED chips 100-L3 of PX1~PX4 are individually wired to reduce the number of electrode terminals of the four-in-one light-emitting unit to 10. In the second wiring layer, the first LED chips and the second LED chips of the two adjacent PX in the up-to-down direction are then connected in parallel by wires, respectively (i.e., the first electrodes of the first LED chips of PX1 and PX3 are connected in parallel to form an electrode terminal 331a, the first electrodes of the first LED chips of PX2 and PX4 are connected in parallel to form an electrode terminal 331b, the first electrodes of the third LED chips of PX1 and PX3 are connected in parallel to form an electrode terminal 334c , and the first electrodes of the third LED chip of PX2 and PX4 are connected in parallel to form an electrode terminal 334d). A total of 8 electrode terminals (i.e., 8 connecting portions) are led out, which effectively reduces the number of electrode pads of the package assembly and thus facilitates placement of chips.

The package assembly according to the above exemplary embodiment does not have a package substrate or holder for carrying the LED chips, the light-emitting units in the m×n array arrangement are mainly held and supported by insulating material layers (including 200, 400 and 500) and wiring layers. The thickness T of the package assembly depends mainly on the thickness TA of the LED chips and the thickness TC of the wiring layer. In some specific embodiments, mini-type LED chips are used which have a thickness TA between 40~150 µm. The thickness TC of the multi-layer wiring layer is between 30~200 µm, more preferably between 50~150 µm. T and TA meets the relationship: 1.4≤T/TA≤10. In this way, the circuit layer can avoid too much stress and too much thermal resistance, and make the total thickness of the package assembly smaller while ensuring the strength of the package structure. For example, in an embodiment, the thickness of the LED chip TA is approximately 80 µm, the thickness of the package assembly can be 120 µm~500 µm, for example, 120~200 µm, and in this case, the thickness of each sub-layer of the wiring layer can be 10~50 µm, ratio 40 µm. In another embodiment, for example, the small size of the package assembly (e.g., 0.4mm × 0.4mm or smaller) does not facilitate gripping from an upper surface of the package assembly. At this time, the thickness T of the package assembly can be increased appropriately so that the sidewall of the package assembly has a larger area for a pickup device to contact and grasp, and preferably, the thickness of the package assembly can be 150~500 µm, such as 180~360 µm. The thickness of the package assembly can be increased by increasing the thickness of the LED chip and/or the thickness of the wiring layer. For example, the thickness of the electrodes of the LED chip may be increased and/or the thickness of each wiring layer may be appropriately increased. The thickness of the via layer is preferably 30~80 µm, and the thickness of the other wiring layers is preferably 50~100 µm. In some specific embodiments, a micro-type LED chip is used, the thickness of the chip TA is between 5 and 10 µm, and the thickness of the multi-layer wiring layer TC is between 20 µm and 200 µm. More preferably, the thickness of the wiring layer TC is between 50 µm and 150 µm. T and TA satisfy the relation: 10≤T/TA≤60, for example, the thickness of the package assembly can be 50~100 µm, or 100~200 µm.

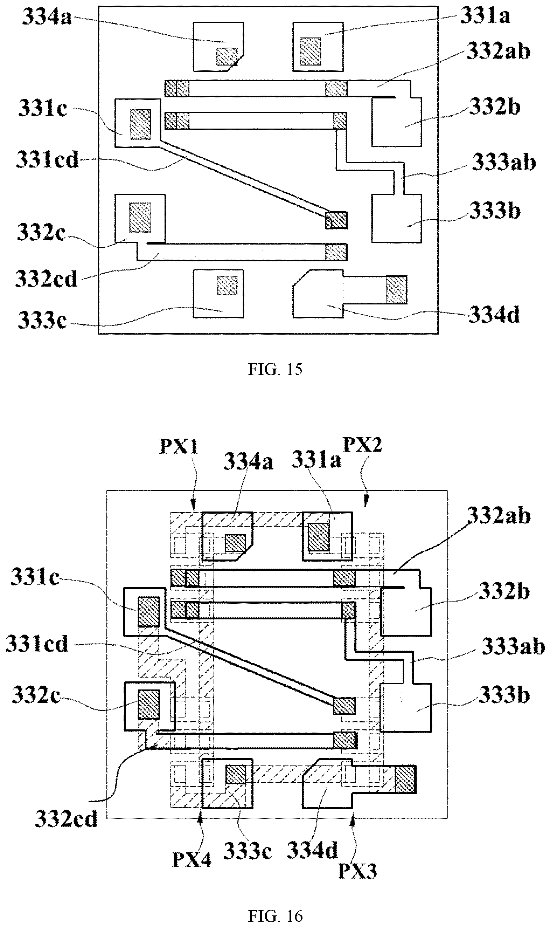

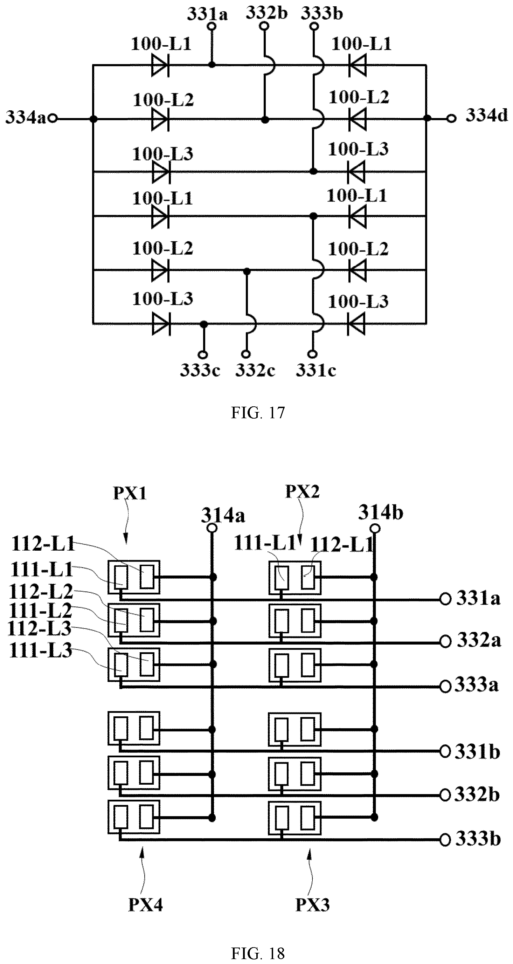

FIGS. 14~17 show another embodiment of the LED package assembly of the present invention. Referring to FIG. 14, the package assembly also includes a plurality of pixel regions PX1~PX4 arranged in an m×n array. Unlike the package assembly shown in Figure 3, the LED chips in the pixel regions have the same polarity direction, which is conducive to improving the efficiency and accuracy of chip alignment. In this embodiment, the first wiring layer includes first wires 311a, 313c and common wires 314a, 314d. 311a connects the first LED chip 100-L1 of the two horizontally adjacent pixel regions PX1 and PX2, 313c connects the third LED chip 100-L3 of the two horizontally adjacent pixel regions PX3 and PX4, 314a connects all LED chips of the longitudinally adjacent pixel regions PX1 and PX4, and 314d connects all LED chips of the longitudinally adjacent pixel regions PX2 and PX3. Referring to FIGS. 15 and 16, the second wiring layer includes connecting portions 331a, 331c, 332b, 332c, 333b, 333c, 334a, 334d and connecting wires 331cd, 332ab, 332cd, 333ab. 331cd connects the first LED chips 100-L1 of the horizontally adjacent pixel regions PX3 and PX4, 332ab connects the second LED chip 100-L2 of the horizontally adjacent pixel regions PX1 and PX2, 332ab connects the second LED chip 100-L2 of the horizontally adjacent pixel regions PX1 and PX2, and 333cd connects the third LED chips 100-L3 of the horizontally adjacent pixel regions PX3 and PX4. FIG. 17 shows an equivalent circuit diagram of the four-in-one package assembly, where 334a and 334d connect all LED chips of the light-emitting units located in the same column along the longitudinal direction, respectively, and 331a, 331c, 332b, 333b, 333c connect the same type of LED chips of light-emitting units located in the same row, respectively.

FIG. 18 shows a further embodiment of the LED package assembly of the present invention. The LED device also includes four pixel regions PX1~PX4 arranged in a 2×2 array, with each pixel region corresponding to a light-emitting unit. The LED chips of the pixel regions are arranged with the same polarity direction. Unlike the LED package assembly shown in FIGS. 14~17, the first wiring layer 330 includes conductive wires 314a and 314b, which connect the second electrodes 112 of all LED chips located in the same column, respectively. The second wiring layer includes conductive wires 331a~333a and 331b~333b, which connect the first electrodes 111 of the same type of LED chips located in the same row, respectively. For example, the wire 331a connects the first electrodes 111-L1 of the first type of LED chips in the first row, the wire 332a connects the first electrodes 111-L2 of the second type of LED chips in the first row, and the wire 331b connects the first electrodes 111-L1 of the first type of LED chips in the second row. The first wiring layer and the second wiring layer are separated from each other by an insulating layer, and are electrically connected to each other by via layer. The connections of wires of the first wiring layer and the second wiring layer can be switched.

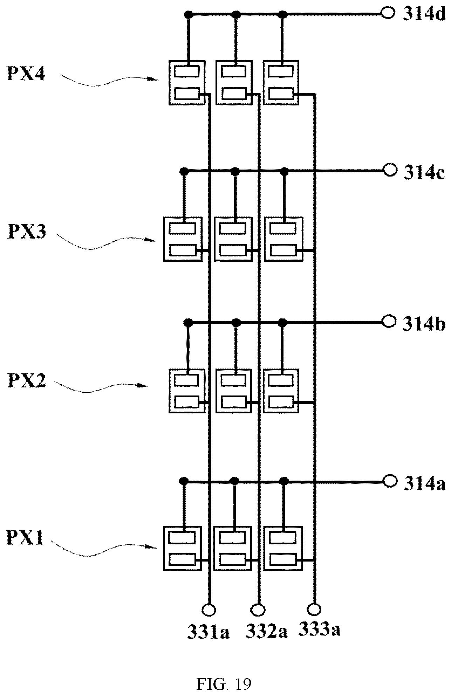

FIG.19 shows a further embodiment of the LED package assembly of the present invention. The LED device also includes four pixel regions PX1~PX4, arranged in a 4×1 array. Firstly, the LED package assembly is rectangular or approximately rectangular in shape, which facilitates assembly when applied to display devices and allows for a minimum number of pads for external connection through a wiring design. Specifically, the first wiring layer includes wires 314a~314d which connect in parallel the second electrodes of the light-emitting units of pixel regions PX1~PX4 in the longitudinal direction, respectively and form four electrode terminals for external connection. The second wiring layer includes wires 331a~333a which connect the same type of first, second, or third LED chips of pixel regions PX1~PX4, and form three electrode terminals for external connection. In this way, the pixel regions PX1~PX4 can form a four-in-one light-emitting module.

In this embodiment, the four-in-one LED package assembly change the arrangement of light-emitting units and uses 4 × 1 arrangement, in which the number of pads P for external connection is equal to 4+a, where a is the number of chips in a single light-emitting unit. In a specific embodiment, each light-emitting unit includes three chips, i.e. a red LED chip 100-L1, a green LED chip 100-L2 and a blue LED chip 100-L3, so only 7 pads are needed, achieving the minimum number of pads, which reduces the size of the package assembly, while conducive to wiring, chip placement at the application end, and reducing the risk of short circuit.

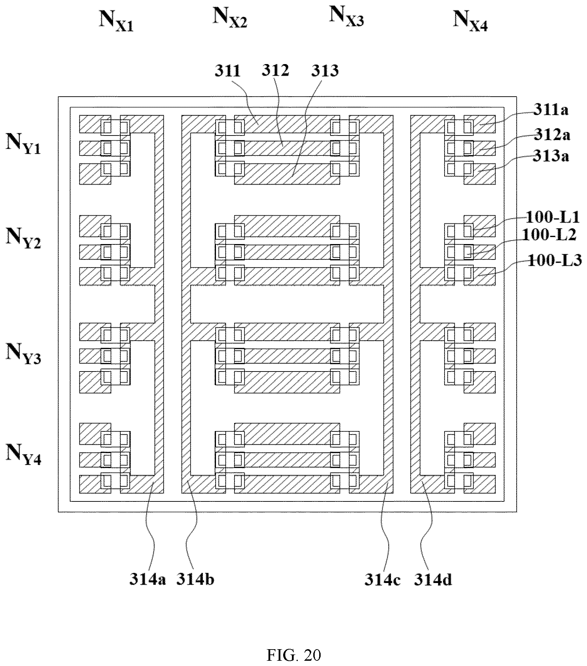

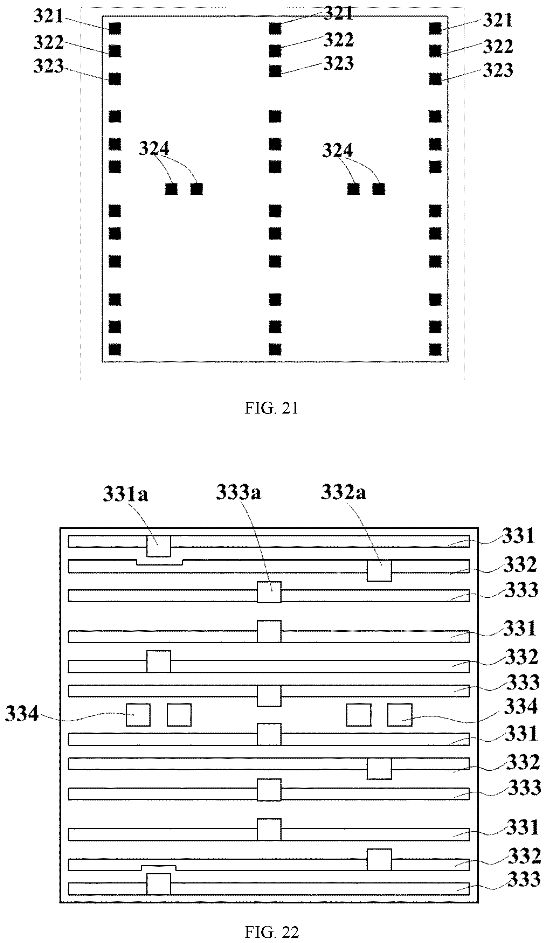

FIGS. 20 to 22 show a further embodiment of the LED package assembly of the present invention. FIG. 20 shows the arrangement of the LED chips and the first wiring layer of this LED package assembly. The LED device also includes 16 pixel regions PX1~PX4 arranged in a 4×4 array. The distance D1 between the individual light-emitting units of the 16-in-1 LED package assembly is preferably 0.1~0.5 mm, for example, 0.2~0.5 mm. The LED chips of each light-emitting unit is first arranged in a column in a first direction, and the first and second electrodes of each LED chip are arranged side by side in a second direction, where the first and second directions are substantially perpendicular to each other. In the first direction, the second electrodes of all the LED chips located in the same column are connected in parallel, and in the second direction, the first electrodes of the same type of LED chips located in the same row are connected in parallel. In addition, the first and second electrodes of LED chips in adjacent columns are in opposite positions, which facilitates the parallel connection of the first electrodes of the same LED chips located in the same row, thus simplifying the wiring of the wiring layer. Specifically, the first wiring layer includes common wires 314a~314d, which are connected to the second electrodes of the LED chips of the columns N_{X1}~N_{X4} of light emitting units, respectively. The first wires include 311~313, where 311 connects the first electrodes of the first LED chips L1 located in the same row of columns N_{X2} and N_{X3}, 312 connects the first electrodes of the second LED chip L2 located in the same row of columns N_{X2} and N_{X3}, and 313 connects the first electrode of the third LED chip L3 located in the same row of columns N_{X2} and N_{X3}. The first wiring also includes wires 311a~313a, which are connected to the first electrodes of the first, second and third LED chips in rows N_{X1} and N_{X4}, respectively. FIG. 21 shows a pattern of the via layer with a plurality of vias, out of which vias 324 are connected to the common wires 314a~314d of the first wiring layer and vias 321~323 are connected to the first wiring of the first wiring layer, respectively. FIG. 22 shows a pattern of the second wiring layer including connecting wires 331~333 and connecting portions 331a~333, 334. The connecting wire 331 connects in parallel the first electrodes of the first LED chips located in the same row, the connecting wire 332 connects in parallel the first electrodes of the second LED chips located in the same row (e.g. rows N_{Y1}~ N_{Y4}), and the connecting wire 333 connects in parallel the third LED chips located in the same row. The connecting portions serve as terminals for external connection. 331a~333a are connected to the connecting wires 331~333 respectively, and334 are connected to 324. In a preferred embodiment, pads can be made in the corresponding area of the connecting portion, and the area outside the pads is covered with ink, epoxy resin or other insulating material to protect the wires of the second wiring layer.

In the embodiment, through the reasonable arrangement of LED chips and wiring layer design, it simplifies the wires of the wiring layer, while improving the reliability of the product. Furthermore, the number of layers of the wiring layer is no more than four (including the pad layer for external connection), which ensures the product is thin and light and conducive to the thin and light end products.

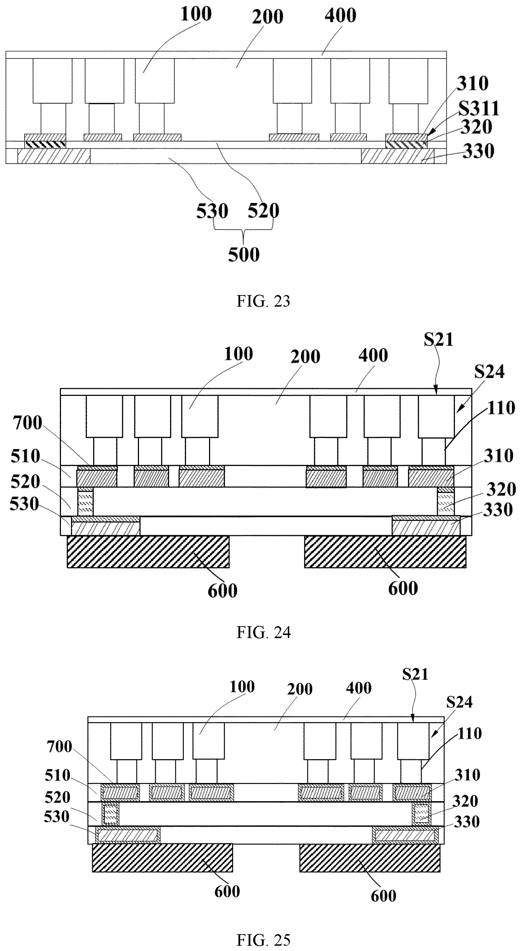

FIG. 23 shows an LED package assembly without a substrate. Unlike the package assembly shown in FIG. 2, the encapsulation layer 200 covers both the sidewalls of the LED chips and the sidewall S311 of the first wiring layer 310. The encapsulation layer 200 is preferably opaque, or has a low light low transmittance, for example, less than 30%, such as 5~20%. Preferably, the encapsulation layer is selected from black materials, such as epoxy resin or silicone with a black colorant. The insulating layers 520 and 530 can be made of light-transmissive or opaque materials.

In summary, the LED package assembly according to the present invention uses the encapsulation layer to hold and encapsulate the pixel dots arranged in an array, and provides a multi-layer wiring layer to connect the LED chips of the pixels in series. Therefore, the present invention does not require solder wires and circuit board with precise wiring, improving reliability and contrast. In addition, the electrode set of the LED chip does not need to be soldered with solder paste onto the board, avoiding poor chip soldering and improving the integration of LED and electronic components, so it indeed achieves the purpose of this invention.

FIG. 24 shows a structure of an LED package assembly of another embodiment of the present invention. Unlike the package assembly shown in FIG. 2, in this embodiment, a metal protective layer 700 is formed on the surface of one or more layers of conductive wires of the wiring layer, which on the one hand prevents metal diffusion of the conductive wires, and on the other hand provides corrosion and oxidation resistance. Preferably, the protective layer has a thickness of 20~500 nm, and its material may be selected from titanium (Ti), titanium nitride (TiN), tungsten (W), tantalum (Ta), tantalum nitride (TaN), molybdenum (Mo), cobalt (Co), and platinum (Pt), etc.

FIG. 25 shows a structure of an LED package assembly of a further embodiment of the present invention. Unlike the package assembly shown in FIG. 14, in the package device shown in this embodiment, the protective layer 700 covers both the surface and the sidewalls of the conductive wires. In this embodiment, the protective layer can better protect the conductive wire, while increasing the adhesion of the wiring layer to the insulating layer 500.

However, the above mentioned are only embodiments of the present invention, and cannot be used to limit the scope of the of the present invention. All the simple equivalent changes and modifications made in accordance with the scope of the patent application and the patent specification of the present invention are still within the scope of the coverage of the present invention.

## Claims

1. A light-emitting diode package assembly, **characterized by** comprising:
a plurality of light-emitting units arranged in an m×n array, where m and n are integers and m×n ≥ 4, each light-emitting unit comprising a first LED chip, a second LED chip and a third LED chip, each LED chip comprising a first surface, a second surface opposite to the first surface, a side surface interconnecting the first surface and the second surface, and an electrode set formed on the second surface, the electrode set comprising a first electrode and a second electrode, the first surface being a light-exiting surface, the LED chips of each light-emitting unit being arranged in a column in a first direction, the first electrode and the second electrode of each LED chip being arranged side by side in a second direction;
an encapsulation layer filling gaps between the LED chips and covering sidewalls of the LED chips;
a wiring layer formed on the second surface of the plurality of LED chips, the wiring layer connecting in parallel the first electrodes of the first LED chips, second LED chips and third LED chips of two or more adjacent light-emitting units in a third direction, and connecting in parallel the second electrodes of the first LED chips, second LED chips and third LED chips of two or more adjacent light-emitting units in a fourth direction, thereby electrically connecting the plurality of light-emitting units to form an all-in-one light-emitting module, wherein the third direction is the same as the first direction and the fourth direction is the same as the second direction, or the third direction is the same as the second direction and the fourth direction is the same as the first direction.

2. The light-emitting diode package assembly of claim 1, **characterized in that** a distance between adjacent light-emitting units is 0.8 mm or less.

3. The light-emitting diode package assembly of claim 1, **characterized in that** a total thickness of the package assembly is between 100 µm and 500 µm.

4. The light-emitting diode package assembly of claim 1, **characterized in that** a total thickness of the package assembly is between 120 µm and 200 µm or between 320 µm and 500 µm.

5. The light-emitting diode package assembly of claim 1, **characterized in that** a thickness of the LED chip is defined as TA, a thickness of the encapsulation layer is defined as TB, a total thickness of the package assembly is defined as T, and T, TA, and TB satisfy formulas: TB/TA ≥ 1, 10 ≥ T/TA ≥ 1.4, and 120 µm ≥ TA ≥ 50 µm.

6. The light-emitting diode package assembly of claim 1, **characterized in that** a thickness of the LED chip is defined as TA, a thickness of the encapsulation layer is defined as TB, a total thickness of the package assembly is defined as T, and T, TA, and TB satisfy the formulas: TB/TA ≥ 1, 60 ≥ T/TA ≥ 10, and 10 µm ≥ TA ≥ 5 µm.

7. The light-emitting diode package assembly of claim 1, **characterized in that** a height difference between the first surfaces of the plurality of LED chips of the light-emitting units is 10 µm or less.

8. The light-emitting diode package assembly of claim 1, **characterized in that** the encapsulation layer is a colored layer, and the first surfaces of the light-emitting units are covered with a light-transmissive layer with a transmittance greater than that of the encapsulation layer.

9. The light-emitting diode package assembly of claim 8, **characterized in that** the light-transmissive layer has a thickness of 20 µm or less.

10. The light-emitting diode package assembly of claim 8, **characterized in that** the transmittance of the light-transmissive layer is 40 ~ 80%.

11. The light-emitting diode package assembly of claim 8, **characterized in that** the transmittance of the light-transmissive layer is 70 or more.

12. The light-emitting diode package assembly of claim 1, **characterized in that** the transmittance of the encapsulation layer is 0 ~ 30%.

13. The light-emitting diode package assembly of claim 1, **characterized in that** the light-emitting units are placed adjacent side by side, wherein the first electrodes of a plurality of LED chips of a first light-emitting unit are adjacent to the first electrodes of a plurality of LED chips of the second light-emitting unit.

14. The light-emitting diode package assembly of claim 1, **characterized in that** the wiring layer comprises a first wiring layer, a via layer, and a second wiring layer, the first wiring layer being formed on the second surfaces of the plurality of LED chips and connecting the first electrodes and second electrodes of the plurality of LED chips, the via layer being formed on the first wiring layer and electrically connected to the first wiring layer, the second wiring layer formed on the via layer and electrically connected to the via layer.

15. The light-emitting diode package assembly of claim 14, **characterized in that** the first wiring layer connects the first electrodes of two or more LED chips of the same light type located in the same row, and the second wiring layer connects the second electrodes of the first, second and third LED chips of two or more light-emitting units located in the same column.

16. The light-emitting diode package assembly of claim 14, **characterized in that** the first wiring layer comprises common wires and first wires, the common wire connecting a plurality of LED chips of two adjacent light-emitting units in the second direction, the first wire connecting in parallel the first LED chips of two adjacent light-emitting units in the first direction, the second wiring layer connecting in parallel the second LED chips and third LED chips of two adjacent light-emitting units in the second direction, respectively.

17. The light-emitting diode package assembly of claim 14, **characterized in that** the first wiring layer comprises common wires and first wires, the common wire connecting a plurality of LED chips of two adjacent light-emitting units in the second direction, the plurality of light-emitting units being divided into two groups, the first wires connecting in parallel the first LED chips of a first group of the light-emitting units and the third LED chips of a second group of light-emitting units, respectively, the second connecting in parallel the first LED chips of the two adjacent light-emitting units in the first direction, the second wiring layer connecting in parallel LED chips of the same type of adjacent light-emitting units in the second direction, respectively, so that LED chips of the same type of adjacent light-emitting units in the first direction are connected in parallel, respectively

18. The light-emitting diode package assembly of claim 14, **characterized in that** the second wiring layer comprises connecting wires and connecting portions, the connecting wires connecting in parallel the LED chips of the same type of different light-emitting units, the connecting portions being used as electrodes for external connection.

19. The light-emitting diode package assembly of claim 18, **characterized in that** a number of the connection portions is n+m×a, where a is the number of the LED chips of each the light-emitting unit, wherein n ≥ m.

20. The light-emitting diode package assembly of claim 14, **characterized in that** a thickness of the via layer is 20 ~ 80 µm.

21. The light-emitting diode package assembly of claim 1, **characterized in that** the wiring layer comprises multiple layers of conductive wires electrically isolated from each other, the number of layers of conductive wires being four or less.

22. The light-emitting diode package assembly of claim 21, **characterized in that** a thickness of at least one layer of the multiple layers of conductive wire is 50 µm or less.

23. The light-emitting diode package assembly of claim 21, **characterized in that** a thickness of at least one layer of the multiple layers of conductive wire is 60 µm or more.

24. The light-emitting diode package assembly of claim 1, **characterized by** further comprising an insulating layer formed on a surface of the encapsulation layer, the insulating layer covering the wiring layer.

25. The light-emitting diode package assembly of claim 24, **characterized in that** the insulating layer comprises a structure of one or more layers, at least one layer of which has a hardness greater than that of the wiring layer.

26. The light-emitting diode package assembly of claim 24, **characterized in that** the insulating layer comprises a structure of one or more layers, at least one layer of which has a hardness of D60 or more.

27. The light-emitting diode package assembly of claim 24, **characterized in that** the insulating layer comprises a structure of one or more layers, at least one layer of which is made of the same material as the first encapsulation layer.

28. The light-emitting diode package assembly of claim 24, **characterized in that** the insulating layer comprises a structure of one or more layers, at least one layer of which is formed by solidifying a photosensitive material.

29. The light-emitting diode package assembly of claim 1, **characterized in that** the insulating layer comprises a structure of one or more layers, at least one layer of which is a transparent layer.

30. The light-emitting diode package assembly of claim 1, **characterized by** further comprising pads, the number of pads P being n + m×a, where a is the number of the LED chips of each the light-emitting unit, wherein n ≥ m.

31. A light-emitting diode package assembly, **characterized by** comprising:
a plurality of light-emitting units arranged in an m×n array, where m and n are integers and m×n ≥ 2, each light-emitting unit comprising a first LED chip, a second LED chip and a third LED chip, each LED chip comprising a first surface, a second surface opposite to the first surface, a side surface interconnecting the first surface and the second surface, and an electrode set formed on the second surface, the electrode set comprising a first electrode and a second electrode, the first surface being a light-exiting surface, the LED chips of each light-emitting unit being arranged in a column in a first direction, the first electrode and the second electrode of each LED chip being arranged side by side in a second direction, the first electrodes and the second electrodes of two adjacent columns of the LED chips are in opposite positions;
an encapsulation layer filling gaps between the LED chips and covering sidewalls of the LED chips;
a wiring layer formed on the second surface of the plurality of LED chips, the wiring layer electrically connecting the plurality of light-emitting units to form an all-in-one light-emitting module.

32. The light-emitting diode package assembly of claim 31, **characterized in that** a distance between adjacent light-emitting units is 0.8 mm or less.

33. The light-emitting diode package assembly of claim 31, **characterized in that** a total thickness of the package assembly is between 120 to 200 µm or between 320 to 500 µm.

34. The light-emitting diode package assembly of claim 31, **characterized in that** a height difference between the first surfaces of the plurality of LED chips of the light-emitting unit is 10 µm or less.

35. The light-emitting diode package assembly of claim 31, **characterized in that** the encapsulation layer is a colored layer, and the first surfaces of the light-emitting units are covered with a light-transmissive layer which has a thickness of 20 µm or less.

36. The light-emitting diode package assembly of claim 31, **characterized in that** the transmittance of the encapsulation layer is 0 ~ 30%.

37. The light-emitting diode package assembly of claim 31, **characterized in that** the wiring layer comprises a first wiring layer, a via layer, and a second wiring layer, the first wiring layer being formed on the second surfaces of the plurality of LED chips and connecting the first electrodes and second electrodes of the plurality of LED chips, the via layer being formed on the first wiring layer and electrically connected to the first wiring layer, the second wiring layer formed on the via layer and electrically connected to the via layer.

38. The light-emitting diode package assembly of claim 37, **characterized in that** the plurality of light-emitting units are arranged in a 2 × 2 array, the first wiring layer comprising common wires and first wires, the common wires connecting a plurality of the LED chips of two adjacent light-emitting units in the second direction, the first wires connecting the second LED chips of two adjacent light-emitting units in the first direction, the second wiring layer connecting in parallel the first LED chips and third LED chips of two adjacent light-emitting units in the first direction respectively.

39. The light-emitting diode package assembly of claim 37, **characterized in that** the first wiring layer comprises common wires and first wires, the common wires connecting a plurality of the LED chips of a plurality of adjacent light-emitting units in a first direction, the first wires connecting the first, second and third LED chips located in the same row of at least two adjacent columns in the second direction, respectively, the second wiring layer connecting the first, second and third LED chips located in the same row in the second direction, respectively.

40. The light-emitting diode package assembly of claim 37, **characterized in that** the second wiring layer comprises connecting wires and connecting portions, the connecting wires connecting in parallel the LED chips of the same type of different light-emitting units, the connecting portions being used as electrodes for external connection.

41. The light-emitting diode package assembly of claim 40, **characterized in that** a number of the connection portions is n+m×a, where a is the number of the LED chips of each the light-emitting unit, wherein n ≥ m.

42. The light-emitting diode package assembly of claim 37, **characterized in that** a thickness of the via layer is 20 ~ 80 µm.

43. The light-emitting diode package assembly of claim 31, **characterized in that** the wiring layer comprises multiple layers of conductive wires electrically isolated from each other, the number of layers of conductive wires being four or less.

44. The light-emitting diode package assembly of claim 43, **characterized in that** a thickness of at least one layer of the multiple layers of conductive wire is 50 µm or less.

45. The light-emitting diode package assembly of claim 43, **characterized in that** a thickness of at least one layer of the multiple layers of conductive wire is 50 µm or less.

46. The light-emitting diode package assembly of claim 31, **characterized by** further comprising an insulating layer formed a surface of the encapsulation layer, the insulating layer covering the wiring layer.

47. The light-emitting diode package assembly of claim 46, **characterized in that** the insulating layer comprises one or more layers of structure, wherein the hardness of at least one layer is greater than the hardness of the wiring layer.

48. The light-emitting diode package assembly of claim 46, **characterized in that** the insulating layer comprises a structure of one or more layers, at least one layer of which has a hardness greater than that of the wiring layer.

49. The light-emitting diode package assembly of claim 46, **characterized in that** the insulating layer comprises a structure of one or more layers, at least one layer of which has a hardness of D60 or more.

50. The light-emitting diode package assembly of claim 46, **characterized in that** the insulating layer comprises a structure of one or more layers, at least one layer of which is formed by solidifying a photosensitive material.

51. The light-emitting diode package assembly of claim 31, **characterized in that** the insulating layer is a structure comprising one or more layers, at least one of which is a transparent layer.

52. The light-emitting diode package assembly of claim 1 or 31, **characterized in that** by further comprising pads, the number of pads P being n + m×a, where a is the number of the LED chips of each the light-emitting unit, wherein n ≥ m.

53. Light-emitting diode package assembly of claim 31, **characterized in that** the wiring layer comprises multiple layers of conductive wires, a first layer of the conductive wires is connected to the electrode sets of the LED chips, a minimum wire width W of each layer of conductive wires and a thickness T of the layer of conductive wires is related as follows: W ≤ T ≤ 2W.

54. The light-emitting diode package assembly of claim 53, **characterized in that** a protective layer is provided on a surface of at least one layer of the multiple layers of conductive wires.

55. The light-emitting diode package assembly of claim 53, **characterized in that** the protective layer has a thickness of 50~200 nm.

56. The light-emitting diode package assembly of claim 53, **characterized in that** each layer of the multiple layers of conductive wires has a minimum wire width W of 10 µm or more.
